# EUROPÄISCHE PATENTSCHRIFT

(11) **EP 0 894 340 B1**
(45) Veröffentlichungstag und Bekanntmachung des Hinweises auf die Patenterteilung: **09.01.2002**
(21) Anmeldenummer: 97920584.6
(22) Anmeldetag: 03.04.1997
(51) Int. Cl.: H01L 41/083

(54) **MONOLITHISCHER VIELSCHICHT-PIEZOAKTOR UND VERFAHREN ZUR HERSTELLUNG**
MONOLITHIC MULTILAYER PIEZO ACTUATOR AND PROCESS FOR ITS PRODUCTION
ACTIONNEUR PIEZO MULTICOUCHE MONOLITHIQUE, ET SON PROCEDE DE PRODUCTION

(30) Priorität: 19.04.1996 DE 19615694
(43) Veröffentlichungstag der Anmeldung: 03.02.1999
(73) Patentinhaber: SIEMENS AKTIENGESELLSCHAFT, 80333 München (DE)
(72) Erfinder: CRAMER, Dieter, D-83607 Holzkirchen (DE); HELLEBRAND, Hans, D-81669 München (DE); LUBITZ, Karl, D-85521 Ottobrunn (DE)
(86) Internationale Anmeldenummer: DE9700687
(87) Internationale Veröffentlichungsnummer: WO9740536

(56) Entgegenhaltungen:
- EP-A- 0 448 349
- US-A- 4 932 119
- US-A- 5 126 618
- US-A- 5 438 232

## Beschreibung

Piezoaktoren bestehen üblicherweise aus mehreren in einem Stapel angeordneten Piezoelementen. Jedes dieser Elemente wiederum besteht aus einer Piezokeramikschicht, die beiderseits mit metallischen Elektroden versehen ist. Wird an diese Elektroden eine Spannung angelegt, so reagiert die Piezokeramikschicht mit einer Gitterverzerrung, die entlang einer Hauptachse zu einer nutzbaren Längenausdehnung führt. Da diese wiederum weniger als zwei Promille der Schichtdicke entlang der Hauptachse beträgt, muß zur Erzielung einer gewünschten absoluten Längenausdehnung eine entsprechend höhere Schichtdicke aktiver Piezokeramik bereitgestellt werden. Mit zunehmender Schichtdicke der Piezokeramikschicht eines einzelnen Piezoelementes steigt jedoch auch die zum Ansprechen des Piezoelementes erforderliche Spannung. Um diese in handhabbaren Grenzen zu erhalten, liegen die Dicken von Piezoeinzelelementen üblicherweise zwischen 20 und 200 µm. Ein Piezoaktor in Mehrschichtbauweise muß für eine gewünschte Längenausdehnung daher eine entsprechende Anzahl an Einzelelementen bzw. -schichten aufweisen.

Bekannte Piezoaktoren in Vielschichtbauweise bestehen daher aus insgesamt zahlreichen Einzelschichten. Zu deren Herstellung werden Piezokeramikgrünfolien alternierend mit Elektrodenmaterial zu einem Stapel angeordnet und gemeinsam zu einem monolithischen Verbund laminiert und gesintert. Ein solches Verfahren ist beispielsweise aus einem Artikel von S. Takahashi et al in Ferroelectrics, 1983, Vol. 90. Seiten 181 bis 190, bekannt. Größere Aktoren mit größerer absoluter Auslenkung werden beispielsweise durch Verkleben mehrerer solcher Stapel erhalten. Ein solcher Aktor bzw. ein solches Verfahren ist beispielsweise aus der EP 0 448 348 A2, der US-A 4 932 119 und der US-A 5 438 232 bekannt. Aus US-A 5 127 618 ist ebenfalls ein Aktor bestehend aus miteinander verklebten Stapeln bekannt. Zwei Stapel sind über eine temperaturkompensierende Zwischenschicht miteinander verbunden. Solche verklebte Stapel zeigen jedoch für viele Anwendungen eine zu geringe Steifigkeit, insbesondere wenn mit dem Piezoaktor hohe Kräfte übertragen werden müssen. Ausreichend hohe Steifigkeiten besitzen nur Piezoaktoren in voll monolithischer Vielschichtbauweise. Nur diese zeigen einen ausreichend festen Verbund der Einzelschichten im Stapel.

Beim Herstellen monolithischer Aktoren in Vielschichtbauweise treten mit zunehmender Höhe jedoch zusätzliche Probleme auf. Die zu einem Stapel laminierten Platten, die zahlreiche Einzelaktoren enthalten, müssen vor dem Sintern zerteilt werden. Dabei werden die Stapel der relativ großflächigen Grünfolien in kleinere Stapel mit der gewünschten Aktorfläche zerteilt. Während niedrige Stapel in Automaten gestanzt werden können, wie es beispielsweise bei Vielschichtkondensatoren in einfacher Weise möglich ist, muß dies bei höheren Stapeln durch einen Vielfach-Sägeprozeß entlang der Trennlinien ersetzt werden.

Bei niedrigen Stapeln kann das Laminieren in Automaten mit kurzen Taktzeiten erfolgen. Höhere Stapel müssen mit erhöhter Sorgfalt laminiert werden, um insbesondere die vertikale Strukturgenauigkeit beim Laminieren aufrechtzuerhalten. Dabei besteht stets die Gefahr, daß durch den angewendeten Druck Querfließprozesse in den Grünfolien zu einer Verschiebung einzelner Schichten gegeneinander führen. Insbesondere in den später zu kontaktierenden Zonen wird dadurch die Kontaktgenauigkeit zerstört.

Die in der Vielschichttechnik verwendeten organischen Binder sind in erster Linie auf die Erfordernisse der Grünfolienherstellung und der Laminierung abgestimmt und müssen vor der Sinterung durch aufwendige Entbinderung in Öfen bei kontrollierter Atmosphäre entfernt werden. Mit zunehmender Stapelhöhe vervielfachen sich aber die Diffusionswege für den Binder bzw. dessen Abbauprodukte bei der Entbinderung. Um eine Zerstörung des Stapels durch einen zu hohen Innendruck des sich zersetzenden Binders zu verhindern, ist ein hoher technischer Aufwand erforderlich, der wesentlich über dem Aufwand bei der Herstellung von Vielschichtkondensatoren liegt.

Wegen der vielen zu lösenden Probleme bei der Herstellung von Piezoaktoren in Vielschichtbauweise sind bekannte monolithische Piezoaktoren in kostengünstiger, bei Vielschichtkondensatoren üblicher Technik bislang auf eine maximale Höhe von ca. 2,5 bis 5 mm beschränkt. Außerdem erreichen diese bekannten Piezoaktoren aus den genannten Gründen nur ein Aspektverhältnis (Höhe/Breite) von maximal ca. 2. Höhere Aktoren und Aktoren mit höherem Aspektverhältnis wurden bislang durch Zusammenkleben mehrerer kleinerer Stapel erhalten, wobei die Steifigkeit des Stapels und damit dessen mechanische Belastbarkeit reduziert wird.

Aufgabe der vorliegenden Erfindung ist es daher, ein einfaches und sicheres Herstellungsverfahren für einen Piezoaktor in monolithischer Vielschichtbauweise anzugeben, welcher ein hohes Aspektverhältnis von mehr als 2 besitzt, welcher sich monolithisch in Stapelhöhen von mehr als 5 mm herstellen läßt, welcher optimale piezoelektrische Eigenschaften und eine hohe mechanische Verbundfestigkeit besitzt.

Diese Aufgabe wird erfindungsgemäß mit einem Verfahren nach Anspruch 1 gelöst. Bevorzugte Ausgestaltungen der Erfindung sind weiteren Ansprüchen zu entnehmen.

Grundlegende Idee der Erfindung ist es, das Laminieren bei begrenzter Stapelhöhe im Nutzen durchzuführen. Nach dem Vereinzeln der Laminate, also dem Auftrennen der großflächigen laminierten ersten Stapel (= erste Verbünde) in kleinere zweite Stapel (= zweite Verbünde) der gewünschten Aktorgrundfläche erfolgt das Entbindern. Mehrere dieser zweiten Verbünde werden nun auf eine Höhe gestapelt, die ein Vielfaches des ersten Nutzens beträgt, und unter leichtem Druck zum erfindungsgemäßen Piezoaktor gesintert. Dabei lassen sich erfindungsgemäße Piezoaktoren mit einer Gesamthöhe von mehr als 5 mm und einem Aspektverhältnis von mehr als 2 erhalten. Durch das Laminieren der ersten Stapel bei relativ geringer Nutzengröße und damit relativ geringer Stapelhöhe läßt sich eine hohe Vertikalgenauigkeit der inneren Elektrodenstrukturen einhalten. Dies ist besonders wichtig, da die Elektroden strukturiert auf die Grünfolien aufgedruckt werden, sodaß in den Elektrodenschichten Ausnehmungen verbleiben, deren exakte Positionierung im Stapel für eine korrekte Kontaktierung besonders wichtig ist. Diese hohe Vertikalgenauigkeit innerhalb eines Verbundes kann beim Übereinanderstapeln mehrerer dieser Verbünde und dem anschließenden gemeinsamen Sintern in einfacher Weise beibehalten werden. Geringfügige Versetzungen, die beim Übereinanderstapeln der Verbünde entstehen können, sind dabei ohne Belang. Das Zerteilen der ersten Verbünde mit begrenzter Stapelhöhe kann in bekannter kostengünstiger Weise durch Schneiden, Stanzen oder Scheren durchgeführt werden. Das Entbindern der gegebenenfalls vereinzelten Verbünde erfolgt in geringer Stapelhöhe von beispielsweise bis zu 2 mm Höhe. So sind für den Binder bzw. dessen Zersetzungsprodukte maximale Diffusionswege von ca. 1 mm zu überwinden. Daher kann zur Entbinderung ein herkömmliches Verfahren ohne zusätzliche aufwendige Verfahrenskontrolle eingesetzt werden.

Die Herstellung erster Verbünde mit im Verbund einheitlichen Elektrodenstrukturen ermöglicht es in einfacher Weise, durch Kombination mehrerer Verbünde mit unterschiedlicher Elektrodenstruktur einen Piezoaktor mit unterschiedlichen Schichtbereichen herzustellen. Die Schichtbereiche können sich dabei durch die genaue Elektrodenstruktur, die Schichtdicken der Einzelschichten oder die elektrische Kontaktierung unterscheiden. So ist es in einfacher Weise möglich, im Piezoaktor mechanisch gekoppelte, aber elektrisch entkoppelte Aktor- und Sensorfunktionen nebeneinander zu realisieren. Auch die Herstellung der Endbereiche, also der Kopf- und Fußbereiche der Piezoaktoren wird so vereinfacht. Diese bestehen aus größeren Bereichen elektrisch inaktiver Keramikschichten, die mit oder ohne dazwischenliegende Elektrodenstruktur realisiert werden können.

Der erfindungsgemäße Piezoaktor und dessen Aufbauverfahren ist dabei völlig unabhängig von den verwendeten Materialien. Für den Aktor kann eine beliebige PZT-(Bleizirkonattitanat) Keramik eingesetzt werden. Zur Herstellung der Elektrodenschichten können verschiedene metallhaltige Pasten verwendet werden. Eine Platinpartikel enthaltende Paste ermöglicht beispielsweise eine Sinterung bei der hohen optimalen Temperatur, die für ein gutes Keramikgefüge und damit für gute piezoelektrische Eigenschaften erforderlich ist. Für geringere Sintertemperaturen sind auch Palladium/Silber-haltige Pasten geeignet.

Im folgenden wird das Verfahren anhand eines Ausführungsbeispiels und der dazugehörigen acht Figuren näher erläutert.
- Figur 1: zeigt eine mit Elektrodenmaterial bedruckte Grünfolie in der Draufsicht.
- Figur 2: zeigt einen Stapel von bedruckten Grünfolien im schematischen Querschnitt.
- Figur 3: zeigt diesen Stapel nach dem Laminieren in perspektivischer Ansicht (= erster Verbund).
- Figuren: 4 bis 6 zeigen verschieden aufgebaute Verbünde, die unterschiedlichen Bereichen im späteren Piezoaktor entsprechen. Dargestellt ist jeweils ein Schnitt entlang der Diagonale A-B von Figur 3.
- Figur 7: zeigt die Anordnung verschiedener Verbünde in einer Matrize und
- Figur 8: zeigt einen mit elektrischen Anschlüssen versehenen fertigen Piezoaktor.

### 1. Herstellung eines Piezoaktors

Die möglichst homogen gemischten Ausgangsmaterialien können nach bekannten Verfahren hergestellt werden und beispielsweise nach dem Mixed-Oxide-Verfahren oder auf chemischen Routen dargestellt werden, beispielsweise nach dem Sol-Gel-Verfahren, dem Citrat-Verfahren, dem Oxalat-Verfahren oder über sonstige metallorganische Vorläuferverbindungen. Während für das Mixed-Oxide-Verfahren sämtliche für die Keramik vorgesehenen Kationen in Form ihrer Oxide miteinander vermischt und anschließend in PZT überführt werden, gehen andere Herstellungsverfahren von gemischten Lösungen metallorganischer Verbindungen der gewünschten Kationen aus. Durch Fällung aus Lösung oder durch allmähliches Eindicken im sogenannten Sol-Gel-Verfahren wird eine äußerst homogene Verteilung der Kationen im späteren Feststoff erzielt. Es wird beispielsweise eine Keramikpulver der nominalen Zusammensetzung Pb_{0,97}Nd_{0,02}(Zr_{0,54}Ti_{0,46})O₃ erhalten.

Nach der Calzinierung wird erneut gemahlen und homogenisiert. Anschließend wird mit einem organischen Binder und Wasser vermischt und so ein Schlicker hergestellt. Damit werden anschließend Grünfolien gezogen oder gegossen, die nach dem Trocknen eine Dicke von zum Beispiel 20 bis 200µm aufweisen.

Nach Trocknen der Grünfolien werden diese mit Elektrodenmaterial versehen, beispielsweise mit einer Paste bedruckt, die Partikel einer Silber/Palladium-Legierung (70/30 Masseverhältnis) in einem Binder bei insgesamt druckbarer Konsistenz enthält. Möglich ist es jedoch auch, Pasten mit Partikeln anderer leitfähiger Metalle wie z.B. Platin zu verwenden.

Auf der Grundfläche einer Grünfolie können dabei Elektrodenstrukturen für mehrere Piezoelemente in einem Schritt aufgedruckt werden. Vorzugsweise wird dabei zur späteren Kontaktierung für jedes einzelne Piezoelement zumindest eine Aussparung in der Elektrodenstruktur vorgesehen.

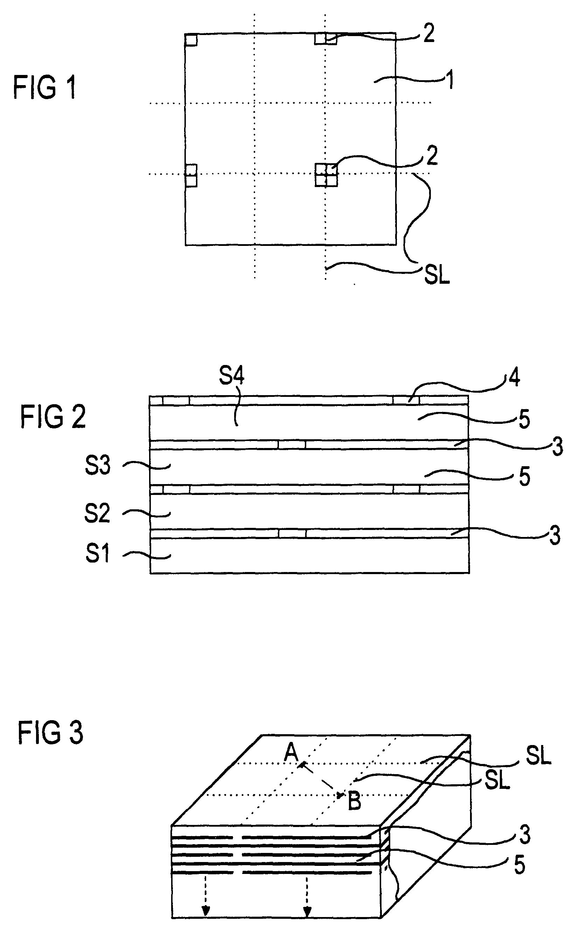

Figur 1 zeigt eine mit Elektrodenmaterial bedruckte Grünfolie in der Draufsicht. Das Bedrucken erfolgt gemäß einem Muster, welches bedruckte Bereiche 1 und unbedruckte freigebliebene Bereiche 2 umfaßt. Die Schnittlinien SL deuten dabei die spätere Aufteilung der großflächigen Grünfolien in kleinere Verbünde mit der gewünschten Aktorfläche an. In der Figur ist eine Grünfolie mit einem Raster von 3 x 3 kleineren Verbünden dargestellt. Entsprechend der gewünschten Grundfläche für den späteren Piezoaktor ist auch ein beliebiges anderes Raster und/oder ein anderes Elektrodenmuster 1, 2 denkbar. Das durch die Schnittlinien in der Figur 1 angedeutete quadratische Raster hat beispielsweise eine Kantenlänge von 14 mm.

Für die Elektrodenschicht wird einseitig soviel Elektrodenmaterial aufgedruckt, daß sich nach der Sinterung eine ca. 2 bis 3 µm dicke zusammenhängende Elektrodenschicht ergibt.

Figur 2: Die mit Elektrodenmaterial bedruckten PiezokeramikGrünfolien S1, S2, S3 ... werden gegebenenfalls getrocknet und anschließend übereinander gestapelt, wobei sich eine alternierende Anordnung von Piezokeramikschichten 5 und Elektrodenschichten 3 ergibt. Bei den Elektrodenschichten wird ebenfalls alternierend so gestapelt, daß über jeder der genannten Aussparungen 4, die den unbedruckten Bereichen 2 von Figur 1 entsprechen, in einer ersten Elektrodenschicht eine mit Elektrodenmaterial bedruckte Fläche 1 in der nächsten benachbarten Elektrodenschicht angeordnet ist. Dies wird bei einem wie in Figur 1 dargestellten Elektrodenmuster durch eine 180° Drehung der Folie um eine senkrecht zur Folie stehende Achse erreicht. In der Figur 2 ist die alternierende Anordnung der mit Elektrodenmaterial 3 bedruckten Grünfolien 5 im Stapel schematisch angedeutet. Durch die alternierende Anordnung ist jede zweite Schicht deckungsgleich bezüglich ihres Elektrodenmusters. In den dazwischenliegenden ebenfalls zueinander deckungsgleichen Schichten sind die Ausnehmungen 4 versetzt.

Auf diese Weise werden Stapel aus so vielen übereinandergelegten Einzelschichten gebildet, daß eine Gesamthöhe von typisch 2 bis 3 mm nicht überschritten wird. Bei einer Grünfoliendicke von beispielsweise 100 um entspricht dies etwa 30 Einzelschichten.

Auf die lose gestapelten Einzelschichten wird nun ein Stempel aufgesetzt, mit dem der Stapel unter einem einachsigen Druck von ca. 100 MPa quasi-isostatisch verdichtet wird. Bereits bei Raumtemperatur, bevorzugt aber unter leicht erhöhter Temperatur und unter atmosphärischen Bedingungen führt die Fließfähigkeit des Binders zu einer Erhöhung der Keramikdichte von 48 auf 60 Prozent der theoretischen Keramikdichte. Dabei erfolgt ein interner Druck- und Volumenausgleich, wobei beispielsweise die Ausnehmungen 4 im Elektrodenmuster vollständig von Keramikmaterial ausgefüllt werden. Auf diese Weise gleichen sich während des Laminierens auch Dichte- und Druckgradienten innerhalb des Stapels bzw. des fertigen Verbunds aus.

Figur 3 zeigt einen so hergestellten Verbund in perspektivischer Darstellung. Die ursprünglichen Ausnehmungen 4 sind nun vollständig mit Keramikmaterial 5 ausgefüllt. Der feste Verbund aus den laminierten Einzelschichten weist noch ausreichend Plastizität auf, so daß er nun in diesem Stadium gemäß dem durch die Schnittlinien vorgegebenen Raster in die entsprechenden Anzahl kleinerer Verbünde mit der gewünschten Grundfläche zerteilt werden kann. Dies kann durch Schneiden oder Stanzen in einem hochautomatisierten Prozeß erfolgen. Anhand von (nicht dargestellten) zusätzlich aufgedruckten Schnittmarken kann die Vereinzelung des Verbundes durch ein Videoverfahren beobachtet und mit einem Rechner überwacht werden.

Im nächsten Schritt werden die so vereinzelten laminierten Stapel (Verbünde) vom Binder befreit. Dies erfolgt in einem thermischen Schritt, wobei eine langsam bis auf ca. 500°C steigende Temperatur und ein parallel dazu ansteigender Sauerstoffpartialdruck gewährleisten, daß der organische Binder ausdiffundiert und sich nicht schlagartig zersetzt und dabei die keramische Struktur zerstört. Die Bedingungen werden also so eingestellt, daß erst in einem späteren Abschnitt des Verfahrens eine Oxidation des Binders bzw. dessen durch thermische Zersetzungen entstandener Fragmente erfolgt. Die geringe Stapelhöhe der Verbünde von beispielsweise 3 mm gewährleistet dabei kurze Diffusionswege für die Zersetzungs- und/oder Oxidationsprodukte des Binders. Im Ausführungsbeispiel ist die Entbinderung bei bis 500°C ansteigender Temperatur in einer maximal 8 Volumen-Prozent Sauerstoff enthaltenden Atmosphäre innerhalb von 24 Stunden abgeschlossen. Bei der Entbinderung werden keine Dimensionsänderungen und daher kein Verziehen im Stapel beobachtet. Die vertikale Strukturgenauigkeit im Verbund bleibt so erhalten.

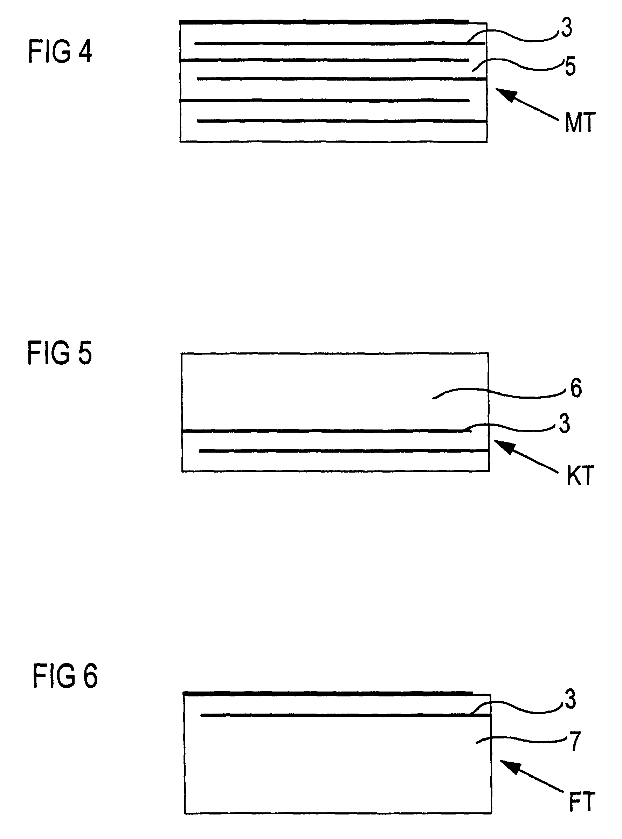

Der erfindungsgemäße Piezoaktor kann aus mehreren unterschiedlichen Verbünden aufgebaut werden. Im einfachsten Fall (siehe dazu auch die Figuren 4 bis 6) besteht der Piezoaktor aus zumindest einem Mittelteil MT, der die bereits beschriebene, regelmäßige, alternierende Elektrodenstruktur aufweist. Am oberen Ende des Stapels wird ein Kopfteil KT vorgesehen. Dieses umfaßt eine Kopfplatte 6, die entweder keine aktive, das heißt elektrisch angeschlossene Elektrodenschicht oder gar keine Elektrodenschicht enthält. Eine allein aus Keramikfolien aufgebaute Kopfplatte 6 kann zur besseren Kraftübertragung des Piezoaktors dienen. Einen entsprechenden Aufbau besitzt auch das Fußteil FT, dessen Fußplatte 7 wie die Kopfplatte 6 des Kopfteils KT aufgebaut sein kann.

Zur Minimierung des Materialeinsatzes ist es dabei möglich, das Muster für die aufgedruckten Elektrodenschichten zu variieren und einen kompletten Piezoaktor einschließlich Kopf- und Fußteil und einer entsprechenden Anzahl von Mittelteilen aus einem einzigen laminierten Stapel herzustellen. Die Anzahl der gleich oder unterschiedlich aufgebauten Mittelteile richtet sich dabei nach der Höhe der gewünschten Auslenkung des fertigen Piezoaktors, die wiederum Höhe des Piezoaktors bestimmt.

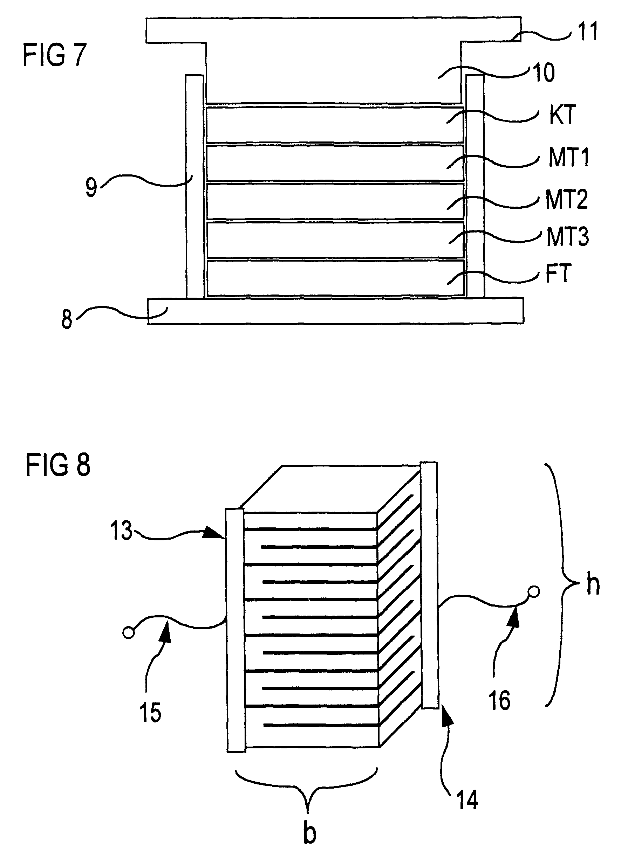

Figur 7 zeigt, wie die entbinderten Kopf-, Mittel- und Fußteile in einer passgenauen Matrize 9 bis zur gewünschten Höhe gestapelt und mit einem Stempel 10 beschwert werden. Die Sinterung erfolgt dann unter leichtem Druck von 10 bis 100 kPa in einer oxidierenden Atmosphäre. Die beispielsweise runde Preßmatrize entspricht in ihrem Durchmesser dem Stanzmaß der übereinander gestapelten Verbünde. Matrize und Stempel sind vorzugsweise wiederverwendbar und bestehen aus Materialien, die während der Sinterung mit der Keramik keine Reaktionen eingehen. Gut geeignet sind beispielsweise Matrizen aus Aluminium- oder Magnesiumoxid. Der Druck kann in einfacher Weise mit einem auf den Stempel aufgelegten Zusatzgewicht erzeugt werden. Auch für das Material dieses Zusatzgewichtes gilt, daß es bei 1130°C in oxidierender Atmosphäre stabil ist und seinerseits die Sinteratmosphäre nicht schädlich beeinflußt.

Auch zur Sinterung wird wieder ein Temperaturprogramm bis zum Erreichen der maximalen Sintertemperatur gefahren. Dies kann in einem einzelnen Ofen mit Temperaturkontrolle oder in einem Durchlaufofen mit entsprechend unterschiedlich temperierten Zonen erfolgen. Im Ausführungsbeispiel ist die Sinterung nach ca. 24 Stunden bei 1130°C abgeschlossen.

Im Ergebnis wird ein monolithischer Piezoaktor erhalten, der eine optimal ausgeprägte Keramikstruktur, aufgrund der hohen Sintertemperatur gute piezoelektrische Eigenschaften und eine hohe Verbundfestigkeit zwischen den Keramik- und den Elektrodenschichten aufweist. Dementsprechend besitzt der monolithische Piezoaktor auch eine hohe Steifigkeit, mit der die Übertragung hoher Kräfte möglich ist.

Figur 8 zeigt einen fertigen Piezoaktor, der zur elektrischen Kontaktierung an einander gegenüberliegenden Ecken streifenförmig mit Elektrodenmaterial kontaktiert ist. Aufgrund der von Einzelschicht zu Einzelschicht alternierenden Elektrodenstruktur erreicht ein solcher Kontakt 13 nur jeweils jede zweite Elektrodenschicht, während der an der gegenüberliegenden Kante befestigte Kontakt 14 die jeweils dazwischenliegenden Elektrodenschichten kontaktiert. So ist eine elektrisch parallele Verschaltung der (zwischen den Elektrodenschichten liegenden) piezoelektrischen Schichten möglich, die einen optimalen Betrieb des Piezoaktors ermöglichen.

Das aus dem Verhältnis Höhe h zur Kantenlänge b ermittelte Aspektverhältnis kann beim erfindungsgemäßen Piezoaktor einen Wert bis ca. 5 annehmen. Prinzipiell lassen sich auch noch höhere und schlankere Piezoaktoren herstellen, doch ist dies mit einer erhöhten Ausfallrate beim Sintern verbunden. Die Matrize ist von ihren Innenabmessungen an das Stanzmaß bzw. das Maß der entbinderten Verbünde angepaßt. Da jedoch beim Sintern ein linearer Schwund in allen drei Raumachsen von ca. 15 Prozent beobachtet wird, kann die Matrize den Stapel beim Sintern nur anfänglich stützen. Im weiteren Fortschritt des Sinterverfahrens kann es daher bei zu hohen bzw. zu schlanken Piezoaktoren zu einem Abknicken des Stapels kommen.

Besonders vorteilhaft ist beim erfindungsgemäßen Piezoaktor zu erwähnen, daß die vertikale Strukturgenauigkeit der Elektroden im Bereich der Kontaktkanten unabhängig vom Aspektverhältnis ist. Aufgrund von Toleranzen und geringfügigen Abweichungen beim Stanzen und Stapeln können bei zwei aufeinanderfolgenden Mittelteilen zwar geringe und für das Verfahren charakteristische Versetzungen der Elektrodenstrukturen auftreten, die jedoch für die Sicherheit der Kontaktierung ohne Belang sind.

## Patentansprüche

1. Verfahren zur Herstellung eines Piezoaktors in monolithischer Vielschichtbauweise,
- bei dem einen Binder enthaltende Piezokeramikgrünfolien (5) einer Dicke von 20 bis 200 µm einseitig mit Schichten aus Elektrodenmaterial (3) bedruckt werden
- bei dem die bedruckten Piezokeramikgrünfolien zu ersten Stapeln von maximal 3 mm Höhe lose so übereinander geschichtet werden, daß sich im Stapel eine alternierende Reihenfolge von Piezokeramikgrünfolien und Elektrodenmaterial ergibt
- bei dem die ersten Stapel unter einachsigem Verpressen zu einem ersten Verbund laminiert werden
- bei dem der erste Verbund bei erhöhter Temperatur vom Binder befreit wird
- bei dem mehrere dieser entbinderten Verbünde (FT, MT, KT) zu einer Gesamthöhe von mehr als 5 mm übereinander gestapelt und unter einachsigem Druck gesintert werden, wobei ein Piezoaktor mit der gewünschten Anzahl an Einzelschichten erhalten wird.

2. Verfahren nach Anspruch 1,
- bei dem Piezokeramikgrünfolien mit einem n-fachen der gewünschten Grundfläche vorgesehen und bedruckt werden und
- bei dem der laminierte erste Verbund vor dem Entbindern durch Schneiden oder Stanzen in n Verbünde der gewünschten Grundfläche zerteilt wird.

3. Verfahren nach Anspruch 1 oder 2,
bei dem das Übereinanderstapeln und Sintern unter Druck in einer Matrize (9) erfolgt.

4. Verfahren nach einem der Ansprüche 1 bis 3,
bei dem die Piezokeramikgrünfolien PZT umfassen und bei dem das Sintern in einer oxidierenden Atmosphäre erfolgt.

5. Verfahren nach einem der Ansprüche 1 bis 4,
bei dem das Sintern unter konstantem Druck von 10 bis 100 kPa erfolgt.

6. Verfahren nach einem der Ansprüche 1 bis 5,
bei dem der Piezoaktor aus unterschiedlichen Verbünden aufgebaut wird, die zumindest ein Kopf- (KT), ein Mittel- (MT) und ein Fußteil (FT) umfassen.

7. Verfahren nach einem der Ansprüche 1 bis 6,
bei dem der Piezoaktor aus mehreren Verbünden mit in sich einheitlicher, aber von Verbund zu Verbund unterschiedlicher Elektrodenstruktur aufgebaut wird.

8. Verfahren nach einem der Ansprüche 1 bis 7,
- bei dem auf die Grünfolien Elektrodenschichten aus einer Silber- und Palladium-haltigen Paste aufgebracht werden
- bei dem die Sinterung bei einer maximalen Temperatur von 1130°C in oxidierender Atmosphäre durchgeführt wird.

## Claims

1. Process for producing a piezoelectric actuator of monolithic multilayer design,
- in which piezoceramic green films (5) containing a binder and having a thickness of 20 to 200 µm are printed on one side with layers of electrode material (3)
- in which the printed piezoceramic green films are layered loosely on one another to form first stacks of a maximum height of 3 mm such that an alternating sequence of piezoceramic green films and electrode material in the layer results
- in which the first stacks are laminated to form a first composite, using uniaxial compression
- in which the first composite is freed of binder at elevated temperature
- in which a plurality of these composites (FT, MT, KT) from which the binder has been removed are stacked on one another to an overall height of more than 5 mm and are sintered under uniaxial pressure, a piezoelectric actuator having the desired number of individual layers being obtained.

2. Process according to Claim 1,
- in which piezoceramic green films of n times the desired base area are provided and printed and
- in which the laminated first composite, before the binder removal, is divided up by cutting or stamping into n composites of the desired base area.

3. Process according to Claim 1 or 2, in which the stacking on one another and sintering under pressure takes place in a die (9).

4. Process according to one of Claims 1 to 3, in which the piezoceramic green films comprise PZT, and in which the sintering takes place in an oxidizing atmosphere.

5. Process according to one of Claims 1 to 4, in which the sintering takes place under constant pressure of 10 to 100 kPa.

6. Process according to one of Claims 1 to 5, in which the piezoelectric actuator is built up from different composites which comprise at least a top part (KT), a middle part (MT) and a bottom part (FT).

7. Process according to one of Claims 1 to 6, in which the piezoelectric actuator is built up from a plurality of composites having an electrode structure which is intrinsically uniform but different from composite to composite.

8. Process according to one of Claims 1 to 7,
- in which electrode layers made of a paste containing silver and palladium are applied to the green films
- in which the sintering is carried out in an oxidizing atmosphere at a maximum temperature of 1130°C.

## Revendications

1. Procédé de fabrication d'un actionneur piézo-électrique en mode de construction multicouche monolithique,
- dans lequel on imprime sur un ruban (5) à vert de céramique piézo-électrique d'une épaisseur de 20 à 200 µm, contenant un liant, d'un côté des couches en matériau (3) d'électrode,
- dans lequel on superpose en couches de manière lâche les feuilles à vert de céramique piézo-électrique imprimées en premières piles d'au maximum 3 mm de hauteur de telle manière que l'on obtient dans la pile une succession alternée de feuilles à vert de céramique piézo-électrique et de matériau d'électrode,
- dans lequel en pressant suivant un seul axe, on lamine les premières piles pour former un premier composite
- dans lequel on débarasse le premier composite du liant à haute température
- dans lequel on empile les uns au-dessus des autres et plusieurs de ces composites (FT, MT, KT) débarassés du liant à une hauteur totale de plus de 5 mm et on les fritte par pression suivant un axe, en obtenant un actuateur piézo-électrique ayant le nombre souhaité de couches individuelles.

2. Procédé suivant la revendication 1,
- dans lequel on prévoit et on imprime des feuilles à vert de céramique piézo-électrique ayant une surface de base ayant n fois la surface de base souhaitée et
- dans lequel on divise, par découpage ou estampage, en n composites ayant la surface de base souhaitée le premier composite laminé avant de le débarasser du liant.

3. Procédé suivant la revendication 1 ou 2, dans lequel on effectue l'empilage et le frittage sous pression dans une matrice (9).

4. Procédé suivant l'une des revendications 1 à 3, dans lequel les feuilles à vert de céramique piézo-électrique comportent du PZT et dans lequel le frittage s'effectue dans une atmosphère oxydante.

5. Procédé suivant l'une des revendications 1 à 4, dans lequel le frittage s'effectue sous pression constante de 10 à 100 kPa.

6. Procédé suivant l'une des revendications 1 à 5, dans lequel l'actuateur piézo-électrique est constitué de différents composites qui comportent au moins une partie (KT) de tête, une partie (MT) médiane et une partie (FT) de pied.

7. Procédé suivant l'une des revendications 1 à 6, dans lequel l'actionneur piézo-électrique est constitué de plusieurs composites ayant une structure d'électrodes en soi uniforme, mais différente d'un composite à l'autre.

8. Procédé suivant l'une des revendications 1 à 7,
- dans lequel on dépose sur les feuilles à vert des couches d'électrodes en une pâte à teneur en argent et en palladium
- dans lequel le frittage est effectué à une température maximum de 1130°C en atmosphère oxydante.
